# FASCICULE DE BREVET EUROPEEN

(11) **EP 3 153 462 B1**
(45) Date de publication et mention de la délivrance du brevet: **17.04.2019**
(21) Numéro de dépôt: 16191926.1
(22) Date de dépôt: 30.09.2016
(51) Int. Cl.: B81B 7/00

(54) **DISPOSITIF POUR CONNECTER AU MOINS UN NANO-OBJET ASSOCIE A UNE PUCE PERMETTANT UNE CONNEXION A AU MOINS UN SYSTEME ELECTRIQUE EXTERNE ET SON PROCEDE DE REALISATION**
VORRICHTUNG ZUM ANSCHLIESSEN MINDESTENS EINES MIT EINEM CHIP ASSOZIIERTEN NANOOBJEKTS, DAS EINE VERBINDUNG ZU MINDESTENS EINEM EXTERNEN ELEKTRISCHEN SYSTEM ERMÖGLICHT, UND IHR HERSTELLUNGSVERFAHREN
DEVICE FOR CONNECTING AT LEAST ONE NANO-OBJECT ASSOCIATED WITH A CHIP ALLOWING A CONNECTION TO AT LEAST ONE EXTERNAL ELECTRICAL SYSTEM AND METHOD FOR MANUFACTURING SAME

(30) Priorité: 05.10.2015 FR 1559467
(43) Date de publication de la demande: 12.04.2017
(73) Titulaire: COMMISSARIAT À L'ÉNERGIE ATOMIQUE ET AUX ÉNERGIES ALTERNATIVES, 75015 Paris (FR)
(72) Inventeur: THUAIRE, Aurélie, 38500 VOIRON (FR); REYNAUD, Patrick, 38420 MURIANETTE (FR); LEDUC, Patrick, 38000 GRENOBLE (FR); ROLLAND, Emmanuel, 38560 JARRIE (FR)
(74) Mandataire: Brevalex

(56) Documents cités:
- EP-A1- 2 145 854
- US-A1- 2012 146 071
- US-A1- 2013 256 919

## Description

### DOMAINE TECHNIQUE ET ART ANTÉRIEUR

La présente invention concerne un dispositif pour connecter des nano-objets à au moins un système électrique externe ainsi qu'un procédé de fabrication d'un tel dispositif.

Par « nano-objets », on entend des objets dont au moins l'une des dimensions se situe dans l'intervalle allant de 0,1 nm à 1000 nm et plus particulièrement de 1 nm à 100 nm, et dans cette catégorie des nano-objets, on inclut notamment les nanoparticules (organiques ou inorganiques), les nano-fils, les molécules ou les associations de molécules, notamment les molécules biologiques telles que les virus et les bactéries.

On cherche aujourd'hui à caractériser des nano-objets de plus en plus petits ou à fabriquer des structures à l'échelle du nanomètre. Il est donc nécessaire de fabriquer un dispositif permettant de mesurer électriquement ces nano-objets et de pouvoir les relier à un système électrique externe configuré pour réaliser un test électrique des nano-objets.

Le document US 2012/0161333 A1 prévoit une connexion électrique d'un nano-objet par la face arrière d'un substrat, à l'aide d'un élément de connexion traversant le substrat.

Pour réaliser un tel dispositif et pouvoir connecter le nano-objet il faut généralement traverser toute l'épaisseur du substrat. Or un tel substrat peut avoir une épaisseur de l'ordre de plusieurs centaines de microns.

Le document WO 2009/022982 A1 prévoit quant à lui une connexion électrique d'un nano-objet par la face arrière d'un substrat, en passant par une cavité formée dans une portion de l'épaisseur du substrat, le nano-objet étant formé sur une portion restante du substrat.

Cette portion restante peut s'avérer fragile. Un autre exemple de dispositif est présenté dans le document US2012/0146071.

Il se pose le problème de réaliser un nouveau dispositif pour connecter un nano-objet ainsi qu'un nouveau procédé de réalisation d'un tel dispositif.

### EXPOSÉ DE L'INVENTION

Un mode de réalisation de la présente invention prévoit un dispositif pour connecter au moins un nano-objet à un système électrique externe, le dispositif comprenant : un support, au moins une première puce dotée de plusieurs zones conductrices et d'au moins un premier nano-objet connecté à une première zone conductrice et à une deuxième zone conductrice parmi lesdites zones conductrices, la première zone conductrice et la deuxième zone conductrice étant disjointes et s'étendant dans un même plan parallèle au plan principal du support, la première puce étant assemblée sur un support de sorte que le premier nano-objet est disposé en regard d'une face supérieure du support, le dispositif étant doté en outre d'éléments de connexion aptes à être connectés au système électrique externe et disposées respectivement sur et en contact de la première zones conductrice et de la deuxième zone conductrice, les premiers éléments de connexion étant formés du côté de la face supérieure du support et étant accessibles du côté de la face supérieure du support.

Une face appelée « première face » de la première puce sur laquelle se situe le nano-objet est disposée en regard de la face supérieure du support. Les éléments de connexion sont situés sur une deuxième face de la première puce, c'est-à-dire la face de la première puce opposée à la première face.

Une face inférieure du support opposée à ladite face supérieure forme une face arrière du dispositif. Les éléments de connexion sont quant à eux accessibles du côté de la face avant du dispositif, c'est-à-dire une face du dispositif opposée à la face arrière du dispositif, autrement dit à la face inférieure du support.

Avec un tel agencement des éléments de connexion, la formation de connexions traversant le support n'est pas indispensable pour permettre de connecter le nano-objet à un système électrique extérieur.

Un tel agencement permet également de mettre en oeuvre des éléments de connexion de courte longueur, ce qui permet notamment de réaliser des mesures électriques de sensibilité améliorée sur le nano-objet.

Selon une possibilité de mise en oeuvre du dispositif, au moins une deuxième puce peut être disposée sur le support, la deuxième puce étant également dotée d'une ou plusieurs deuxièmes zones conductrices et d'un deuxième nano-objet connecté auxdites deuxièmes zones conductrices.

Avantageusement, le support comporte au moins une cavité au niveau de sa face supérieure, le premier nano-objet ne se trouvant donc pas en contact avec ledit support.

On peut ainsi réaliser un dispositif dont l'encombrement est moindre tout en préservant ce nano-objet et en assurant une protection de celui-ci.

Selon un mode de réalisation, un autre élément de connexion électrique connecté au premier nano-objet traverse le support, cet autre élément de connexion débouchant sur une face inférieure du support opposée à la face supérieure.

Le dispositif peut comprendre au moins un circuit électronique doté d'un ou plusieurs composants, le circuit étant assemblé sur la face supérieure du support.

Le dispositif peut également comprendre un circuit électronique intégré au support.

Le dispositif peut également comprendre un circuit électronique intégré au support assemblé sur la première puce et connecté au premier nano-objet.

Le circuit électronique peut être doté de moyens d'amplification et/ou de filtrage, afin de filtrer et/ou amplifier des signaux électriques de test du nano-objet.

Selon un autre aspect, un mode de réalisation de la présente invention prévoit un procédé de réalisation d'un dispositif pour connecter au moins un nano-objet à un système électrique externe, le procédé comprenant des étapes consistant à :
- assembler sur un support une première puce dotée de zones conductrices et d'un premier nano-objet connecté auxdites zones conductrices, l'assemblage de la première puce sur le support étant réalisé de sorte que le premier nano-objet est disposé en regard d'une face supérieure du support,
- réaliser du côté de la face supérieure du support un ou plusieurs premiers éléments de connexion disposées sur et en contact des zones conductrices.

Avantageusement, le nano-objet est situé sur une première face de la première puce, opposée à une deuxième face, le procédé comprenant en outre entre l'assemblage et la réalisation des éléments de connexion : une étape consistant à retirer une épaisseur de la première puce du côté de sa deuxième face.

Ainsi, on effectue ce retrait une fois l'assemblage réalisé ce qui permet de réaliser un accès aux zones conductrices de la puce sans la détériorer, le support assurant une rigidité mécanique lors du retrait.

La première puce peut être formée à partir d'un substrat sur lequel lesdites zones conductrices sont réalisées.

Le procédé peut comprendre en outre une étape de découpe du substrat en plusieurs puces. Cela permet notamment une réalisation collective de puces avant assemblage avec le support.

Selon une possibilité de mise en oeuvre du procédé dans lequel le nano-objet est formé sur une première face de la première puce après l'étape de découpe du substrat, et dans lequel, préalablement à la découpe on forme un capot de protection sur la première face, on effectue le retrait de ce capot de protection préalablement à la formation du premier nano-objet sur la première face de la première puce.

Le nano-objet peut être formé sur une première face de la première puce avant l'étape de découpe du substrat, la découpe du substrat étant alors réalisée après formation d'un capot de protection sur la première face.

Selon une possibilité de mise en oeuvre du procédé, le premier nano-objet peut être positionné sur une zone d'intérêt de la première puce en se servant de motifs ou de repères délimitant cette zone d'intérêt. Les motifs peuvent être par exemple sous forme de trous ou de tranchées.

Après assemblage de la première puce sur le support, on peut former une paroi avantageusement isolante autour de la première puce. Cette paroi isolante peut servir à la fois de protection et d'isolation électrique de la première puce.

Une possibilité de mise en oeuvre du procédé prévoit une étape d'assemblage d'un bloc factice sur la face supérieure du support.

Un tel bloc factice lorsqu'il est accolé à la première puce peut permettre d'améliorer la cohésion de l'assemblage entre la première puce et le support.

Un tel bloc factice peut également permettre de limiter le relief de l'assemblage entre support et première puce.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 sert à illustrer un dispositif suivant un mode de réalisation de la présente invention pour connecter au moins un nano-objet formé sur une puce reportée sur un substrat ;
- les figures 2A-2L illustrent, par le biais de vues en coupes transversales un exemple de procédé de réalisation d'un tel dispositif;
- la figure 3 illustre une variante de réalisation dans lequel, le substrat est doté d'au moins une cavité d'accueil du nano-objet ;
- la figure 4 illustre un exemple de réalisation particulier dans lequel au moins un élément de connexion supplémentaire traverse l'épaisseur du substrat pour permettre une prise de contact sur sa face inférieure ;
- la figure 5 illustre un exemple de réalisation dans lequel un circuit électronique doté d'un bloc de filtrage et/ou d'amplification est disposé sur le même substrat que celui sur lequel la puce dotée du nano-objet est reportée ;
- la figure 6 illustre un exemple de réalisation dans lequel le substrat sur lequel la puce est reportée est doté d'au moins un circuit intégré avec un ou plusieurs composants actifs ;
- la figure 7 illustre un exemple de réalisation dans lequel on reporte un circuit intégré sur la puce qui est assemblée au substrat et est dotée d'un nano-objet ;
- la figure 8 illustre un exemple d'agencement de plots de connexion connectés à un nano-objet disposé sur une puce elle-même assemblée à un substrat ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation, telle que « avant », « arrière », « supérieure », « inférieure » etc. d'une structure s'appliquent en considérant que la structure est orientée de la façon illustrée sur les figures.

### EXPOSÉ DÉTAILLÉ DE MODES DE RÉALISATION PARTICULIERS

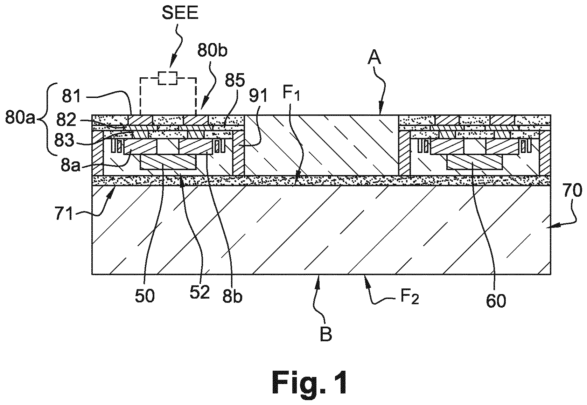

On se réfère à présent à la figure 1 donnant une vue en coupe schématique d'un mode de réalisation particulier d'un dispositif pour connecter un ou plusieurs nano-objet(s) à un système électrique externe.

Dans l'exemple de la figure 1, le dispositif est destiné à connecter un premier nano-objet 50, par exemple sous forme d'une molécule, à un système électrique externe SEE.

Le système électrique peut-être notamment un circuit intégré doté d'un moyen de caractérisation ou d'un moyen de commande ou encore d'un moyen de lecture. Ce système permet, par exemple, de déterminer des propriétés électriques du nano-objet 50.

Le système électrique externe SEE peut être configuré pour recevoir et/ou envoyer des signaux vers le nano-objet. Ces signaux peuvent être de différentes natures en fonction des caractéristiques physiques que l'on cherche à mesurer ou à transmettre. Le système électrique peut être adapté pour mesurer des grandeurs physiques telles que la tension, le courant, l'impédance, la capacité. Les paramètres de mesure seront adaptés de telle manière à ne pas endommager le nano-objet. Typiquement, lors de la mesure d'un nano-objet sous forme d'un ensemble de fibres biologiques de plusieurs microns de longueur et de 6 à 10 nm de diamètre, on peut appliquera une tension par exemple de l'ordre de 3V et mesurer un courant I de l'ordre par exemple d'une dizaine de nano-Ampère traversant ledit nano-objets.

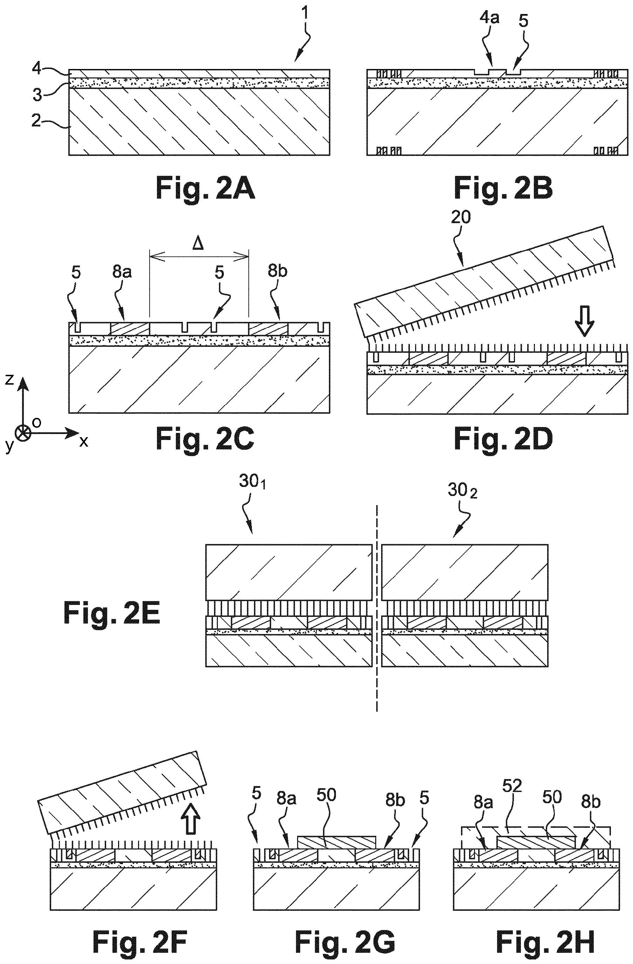

Le nano-objet 50 est intégré sur un élément, tel qu'une puce 30₁, muni de zones conductrices 8a, 8b auxquelles le premier nano-objet 50 est connecté. Typiquement, les zones conductrices 8a, 8b sont disjointes et s'étendent dans un même plan parallèle au plan principal du support. Par plan principal du support on entend un plan passant par le support et qui est parallèle au plan [O ;x ;y°] du repère [O ;x ;y ;z] sur la figure 2C. Les zones conductrices 8a, 8b sont avantageusement des zones semi-conductrices dopées d'une même couche.

La puce 30₁ repose et est assemblée sur une face supérieure F1 d'un support 70. La puce 30₁ peut être retournée sur le support 70 de sorte qu'une face appelée « première face » sur laquelle le nano-objet 50 est placé se trouve en regard de la face supérieure du support 70.

Le système électrique externe SEE est connecté au nano-objet 50 par le biais d'éléments de connexion 80a, 80b disposés sur et en contact des zones conductrices 8a, 8b de la première puce 30₁ afin de pouvoir faire circuler un courant à travers le nano-objet 50. Les éléments de connexion 80a, 80b sont placés du côté de la face supérieure F₁ du support 70 et d'une face de la première puce 30₁ appelée « deuxième face », la deuxième face étant opposée à ladite première face. Ces éléments de connexion 80a, 80b peuvent être formés d'au moins un plot 81 et/ou d'au moins une ligne conductrice 82 et/ou d'au moins un via conducteur 83 traversant une couche ou un empilement de couches isolantes 85 recouvrant la première puce 30₁.

Avec un tel agencement, les éléments de connexion 80a, 80b sont avantageusement accessibles en face avant A du dispositif, du côté de l'assemblage support-puce où se trouve le nano-objet 50. La face arrière B du dispositif opposée à ladite face avant A correspond à la face inférieure F2 du support, autrement dit à la face du support qui est opposée à sa face supérieure F1.

L'agencement des éléments 80a, 80b permet de réaliser une connexion de courte distance entre le nano-objet 50 à caractériser et le système externe électrique, ce qui permet d'améliorer la sensibilité de mesure. On réalise en particulier une connexion plus courte, par exemple de longueur de l'ordre de 400 nm qu'avec un élément de connexion traversant le support 70, ce dernier pouvant avoir une épaisseur par exemple de l'ordre de plusieurs centaines de micromètres et typiquement de l'ordre de 725 µm.

Le support 70 est par exemple sous forme d'un substrat semi-conducteur et est apte à accueillir, comme dans l'exemple de réalisation particulier de la figure 1, au moins une autre puce 30₂. Cette autre puce 30₂ peut être dotée également d'un autre nano-objet 60, par exemple d'une autre molécule. Ainsi, on peut co-intégrer sur le même support 70 plusieurs puces 30₁, 30₂ avec des nano-objets différents. Un mode de réalisation particulier du dispositif prévoit d'intégrer à la fois des nano-objets organiques et inorganiques. Les puces 30₁, 30₂ peuvent provenir de laboratoires ou de lieux de fabrications différents.

Avec un tel dispositif, on peut également réaliser un adressage individuel et une mesure électrique sur chacune des puces prise individuellement ou en variante mettre en oeuvre une caractérisation électrique collective de plusieurs puces 30₁, 30₂, et éventuellement interconnecter plusieurs puces en série à l'aide d'une reprise de contact collective.

Un exemple de test électrique consiste à appliquer une tension entre les éléments 80a, 80b connectés respectivement aux zones conductrices 8a, 8b de la première puce 30₁ et à mesurer un courant traversant le nano-objet par exemple sous forme d'une molécule.

Dans l'exemple de réalisation particulier de la figure 1, le support 70 sur lequel repose les puces 30₁, 30₂, est recouvert d'une couche 71 à base de matériau diélectrique par exemple du SiO₂, qui peut servir à la fois d'interface de collage et d'isolation électrique.

Une couche d'encapsulation 52 recouvrant et protégeant le nano-objet 50 peut être également prévue. Cette couche d'encapsulation 52 peut être par exemple une couche de matériau semi-conducteur ou avantageusement une couche isolante.

Pour améliorer l'isolation électrique et la protection de la première puce 30₁, celle-ci peut être également entourée par des parois isolantes 91 par exemple à base de matériau polymère ou de de SiO_{2,} configurées pour former une enceinte isolante de protection autour de la puce 30₁.

Un exemple de procédé de fabrication d'un dispositif du type de celui précédemment décrit va à présent être donné en liaison avec les figures 2A-2L.

Le matériau de départ de ce procédé peut être un substrat 1 de type semi-conducteur sur isolant (figure 2A) en particulier de type SOI (pour « Silicion On Insulator ») ou GeOI ou SiGeOI comprenant une couche 2 de support semi-conductrice revêtue d'une couche isolante 3 dite de BOX (pour « Burrried Oxide »), elle-même revêtue d'une couche semi-conductrice 4 superficielle, par exemple à base de Si, ou de Ge ou de SiGe. La couche superficielle 4 peut avoir une épaisseur par exemple comprise entre 10 nm et 1 µm, tandis que la couche SiO₂ comprise entre 10 nm et plusieurs µm. La couche 2 de support semi-conductrice peut, quant à elle, avoir une épaisseur comprise entre 625 µm et 1.5 mm.

On réalise ensuite des motifs dans la couche superficielle 4, en particulier sous forme de tranchées 5 afin de délimiter une ou plusieurs zones d'intérêts 4a de la couche superficielle 4, chaque zone d'intérêt étant apte à accueillir au moins un nano-objet (figure 2B). Les tranchées 5 forment ainsi des marques de localisation situées autour des zones d'intérêts 4a et permettant de localiser ces zones 4a. La ou les zones d'intérêts 4a peuvent avoir une surface par exemple comprise entre 10 nm² et 1 mm², en particulier entre 0.01 µm x 0.01 µm et 10 µm x 10 µm. Pour réaliser les tranchées 5 on utilise par exemple une technique de photolithographie lors de laquelle on forme un masque de résine, puis on effectue une gravure de la couche semi-conductrice 4 à travers ce masque et on retire enfin le masque de résine.

Ensuite, on forme des zones conductrices dans la couche superficielle 4.

Ces zones conductrices sont dans cet exemple des zones dopées 8a, 8b réalisées dans la (ou les) zone(s) d'intérêt 4a en particulier par implantation à travers un masquage (non représenté).

Les zones dopées 8a, 8b réalisées à l'intérieurd'un périmètre délimité par les tranchées 5 ou marques de localisation sont aptes à être mises en contact électrique avec au moins un nano-objet. Typiquement, on peut réaliser deux zones dopées P ou N disjointes par zone d'intérêt 4a. La distance Δ entre les deux zones dopées 8a, 8b peut être comprise par exemple entre plusieurs nanomètres et plusieurs centaines de microns. Cette distance Δ dépend de la taille du nano-objet qui sera mis en contact avec ces zones 8a, 8b.

A titre d'exemple, une distance Δ de 0.1 µm peut être prévue lorsque le nano-objet a une longueur de l'ordre de 150 nm.

On peut ensuite effectuer une étape de préparation de surface de la couche superficielle 4 afin en particulier de la fonctionnaliser et pouvoir éventuellement réaliser ultérieurement sur cette surface un greffage de molécule(s) ou bien la fabrication d'un nano-objet.

Cette fonctionnalisation peut être réalisée par traitement thermique et/ou traitement chimique. Elle est de préférence précédée d'un nettoyage de surface pour enlever d'éventuels contaminants. Un nettoyage de type communément appelé « RCA » ou « piranha » peut être effectué. Puis, on réalise un nettoyage dans une solution d'acide fluorhydrique (HF) permettant d'obtenir une surface hydrophobe, composée en particulier de liaisons Si-H. On effectue ensuite un traitement thermique afin d'ordonner les atomes à la surface.

Typiquement, un recuit entre 850°C et 1200°C pendant plusieurs minutes, par exemple de l'ordre de 7 min, sous atmosphère contenant de l'hydrogène, permet d'obtenir une surface fonctionnalisée saturée en Si-H où pourront se fixer des molécules.

Avantageusement, le traitement thermique mis en oeuvre lors de la préparation de la surface de la couche superficielle 4 permet également d'activer les dopants P ou N implantés précédemment afin de réaliser les zones conductrices 8a, 8b. Lorsqu'on effectue un tel traitement sur une plaque de silicium Si(100), on obtient une surface reconstruite Si(001)-(2x1).

Ensuite, un capot 20 temporaire de protection peut être assemblé sur une première face du substrat 1 c'est-à-dire celle sur laquelle la couche superficielle 4 se situe (figure 2D).

Une protection hermétique de la première face du substrat 1 est ainsi assurée. L'assemblage du capot 20 sur le substrat 1 peut être réalisé par un collage par adhésion moléculaire, en particulier de type hydrophobe et lors duquel la surface rendue hydrophobe de la couche superficielle 4 et par exemple saturée par des liaisons Si-H peut être liée à une autre surface dotée de liaisons Si-H. Le collage par adhésion moléculaire peut être réalisé à température ambiante, typiquement de l'ordre de 20°C.

Puis, on effectue une découpe du substrat 1 assemblé au capot temporaire 20 en plusieurs éléments 30₁, 30ₖ également appelés puces (figure 2E).

Les puces 30₁, 30ₖ peuvent avoir une taille comprise par exemple entre plusieurs mm et plusieurs dizaines de centimètres, typiquement de l'ordre de 1 cm². La découpe peut éventuellement être réalisée de sorte à produire des éléments ou puces de tailles différentes les unes par rapport aux autres. Cette découpe est par exemple réalisée à l'aide d'un équipement doté d'une lame fine par exemple de l'ordre de 100 µm d'épaisseur.

Sur la figure 2F, une étape ultérieure de retrait du capot 20 temporaire sur une première puce 30₁ parmi la pluralité de puces découpées est illustrée. L'enlèvement du capot temporaire 20 peut être effectué, par exemple, à l'aide d'une lame que l'on insère au niveau de l'interface de collage entre le capot 20 et la première puce 30₁ et dont on se sert ensuite comme d'un levier.

On forme ensuite un nano-objet 50 sur la face supérieure de la première puce 30₁ c'est-à-dire celle sur laquelle les zones conductrices 8a, 8b ont été réalisées (figure 2G). Le nano-objet 50 est disposé de sorte à être en contact avec une partie des zones implantées. Le nano-objet 50 peut être par exemple sous forme de nano-particules organiques ou inorganiques, de molécule(s), en particulier de molécule(s) biologique(s), telle qu'une protéine, de l'ADN, un virus, ou un anti-corps. Selon un autre exemple, le nano-objet 50 peut être un nano-fil

Par « formation » du nano-objet », on inclus notamment une modification de surface (fonctionnalisation) et/ou un greffage, ou un collage, ou un dépôt suivi éventuellement d'une structuration.

Le placement précis du nano-objet 50 sur la zone d'intérêt 4a et les zones conductrices 8a, 8b de cette zone 4a peut être effectuée de manière automatisée par un équipement configuré pour détecter les marques 5 de localisation.

Une couche d'encapsulation 52 peut être ensuite formée de sorte à protéger le nano-objet 50 (figure 2H).

Pour un nano-objet 50 de nature organique, la couche d'encapsulation 52 peut être par exemple prévue à base de résine. La couche d'encapsulation 52 est formée de préférence à basse température. Pour un nano-objet 50 inorganique, on peut par exemple prévoir une couche d'encapsulation 52 en silicium ou en oxyde de silicium. Un exemple de réalisation particulier prévoit de former une couche d'encapsulation 52 semi-conductrice par croissance par épitaxie sur la couche superficielle 4 du substrat ou une couche isolante réalisée par exemple par un dépôt. Pour un nano-objet 50 de plusieurs nanomètres de hauteur, on prévoit par exemple une couche d'encapsulation 52 de l'ordre de 20 nm d'épaisseur.

Ensuite, on assemble la première puce 30₁ isur un support 70, par exemple un substrat semi-conducteur à base de silicium, ou de germanium, ou de SiGe, ou bien en verre ou en mica. Le support 70 peut être en particulier une plaque (« wafer » selon la terminologie anglo-saxonne) de silicium de diamètre de l'ordre de 100 mm, ou 150 mm, ou 200 mm, ou 300 mm, ou plus. Le support 70 d'accueil de la première puce 30₁ peut avoir une épaisseur importante par exemple de l'ordre de 725 µm.

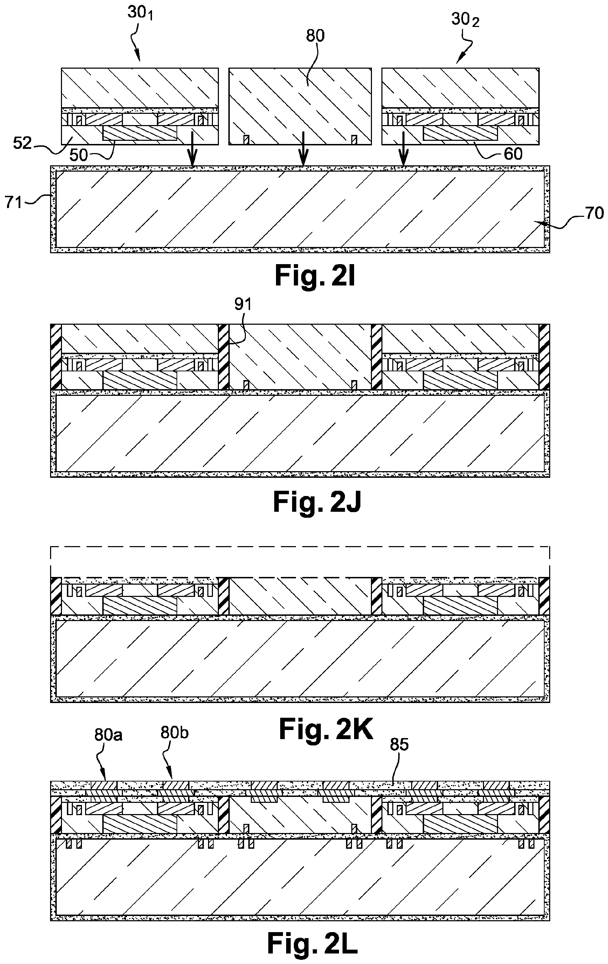

Dans l'exemple particulier de la figure 2I, le support 70 est revêtu sur sa surface d'une couche de passivation 71 par exemple à base de SiO₂ ou de Si₃N₄ par exemple.

A ce stade du procédé, le support 70 sur lequel on assemble la puce 30₁ peut être doté d'un circuit électronique intégré doté en particulier d'un ou plusieurs composants actifs formant des moyens de filtrage et/ou d'amplification.

L'assemblage de la puce 30₁ et du support 70 est réalisé par exemple par collage ou adhésion moléculaire. On peut effectuer pour cela préalablement une séquence de nettoyage de surface afin d'éliminer d'éventuels contaminants et rendre la surface de la première puce 30₁ et du support 70 hydrophiles. Un collage hydrophile de la première puce 30₁ sur le support 70 permet d'obtenir une bonne adhésion. Cette adhésion moléculaire peut être améliorée en effectuant un recuit thermique, par exemple à une température de l'ordre 200°C sous atmosphère d'azote ou d'argon. Un collage de bonne qualité est obtenu lorsque le support 70 est revêtu d'une couche 71 d'oxyde de silicium.

Une telle couche est typiquement réalisée par oxydation thermique d'un substrat de silicium. La couche d'oxyde thermique obtenue a par exemple une épaisseur comprise entre 50 nm et 1 µm.

Le support 70 peut être prévu pour accueillir plusieurs éléments ou puces. Dans l'exemple d'assemblage illustré sur la figure 2I, on effectue également un assemblage entre une deuxième puce 30₂ et le support 70. Cette deuxième puce 30₂ est munie d'un nano-objet 60, qui peut être différent de celui agencé sur la première puce 30₁. La deuxième puce 30₂ peut être issue de la découpe décrite précédemment en liaison avec la figure 2E ou bien avoir été fabriquée totalement indépendamment de la première puce 30₁.

Afin de pouvoir repérer l'emplacement prévu pour les puces 30₁, 30₂ on peut réaliser des repères d'alignement sur la face supérieure du support 70.

Les puces 30₁, 30₂ peuvent également être dotées de marques d'alignement spécifiques en face supérieure pour permettre de les disposer précisément sur le support 70. Les repères et marques d'alignement peuvent être par exemple sous forme de tranchées. Les marques d'alignement prévues sur une puce 30₁ peuvent avoir été réalisées en même temps que les marques de localisation 5 dont la réalisation a été décrite précédemment en liaison avec la figure 2B.

Un alignement ou une superposition des repères et marques d'alignement des puces 30₁, 30₂ et du support 70 peut donc être effectué(e) afin de permettre de vérifier le bon positionnement de ces deux parties du dispositif l'une par rapport à l'autre.

Un ou plusieurs éléments supplémentaires peuvent être également assemblés sur la face supérieure du support 70. Dans l'exemple de réalisation illustré sur la figure 2I, on assemble en outre un élément supplémentaire sous forme d'un bloc 80 factice (« dummy » selon la terminologie anglo-saxonne) qui ne dispose ni de composant ni d'élément de connexion mais peut être prévu pour permettre d'uniformiser les contraintes sur le support 70 et/ou de limiter le relief. Un tel bloc 80 factice participe au maintien solidaire des éléments de l'assemblage et d'éviter un décollement des puces 30₁, 30₂ du support 70. Dans ce cas, le bloc 80 peut avoir une hauteur sensiblement égale à celle des puces 30₁, 30₂ assemblés sur le support 70. Dans un mode de réalisation avantageux ce bloc factice peut avoir sensiblement les mêmes dimensions que la puce à laquelle il est juxtaposé

Ensuite, une fois cet assemblage réalisé, on peut former une couche isolante 91 autour des puces 30₁, 30₂ et du bloc 80 (figure 2J). Cette couche isolante 91 peut être agencée de sorte à combler des interstices ou espaces entre les puces 30₁, 30₂ et le bloc 80 et former une paroi latérale ou une enceinte permettant de favoriser le maintien solidaire de l'assemblage formé entre les puces 30₁, 30₂, et le support 70. Une telle couche isolante 91 peut être ainsi prévue pour permettre d'empêcher le décollement des puces 30₁, 30₂. La couche isolante 91 peut être par exemple à base d'oxyde de silicium ou de polymère. La couche isolante 91 peut également permettre de réaliser une isolation électrique puce à puce, de former une barrière de protection des flancs latéraux des puces 30₁, 30₂.

Une telle étape est particulièrement adaptée lorsqu'on effectue un assemblage de puces de très petite taille, en particulier de surface inférieure à 1 mm² car plus la surface en contact avec le substrat 2 est petite et plus le risque de désolidarisation entre la puce et le support est généralement important.

Dans le cas où il s'avère nécessaire d'éliminer une partie de la couche isolante 91 recouvrant les puces 30₁, 30₂, on peut ensuite effectuer une planarisation par CMP (pour Chemical Mechanical Polishing).

Puis, on réalise un amincissement de l'assemblage, en particulier du côté où les puces 30₁, 30₂ sont agencées.

Ainsi, on retire une portion de la deuxième face de la première puce 30₁, de la deuxième puce 30₂ et du bloc 80 (figure 2K).

Cette étape peut être réalisée jusqu'à atteindre la couche isolante 3 du substrat 1 de départ à partir duquel la première puce 30₁ a été réalisée. Lorsque le substrat 1 de départ est par exemple une plaque de diamètre 200 mm, on peut retirer une épaisseur par exemple de l'ordre de 725 µm de silicium pour réaliser un tel amincissement et parvenir à la couche isolante 3 de BOX. Ce retrait peut être réalisé par gravure. Le support 70 permet d'assurer un maintien rigide des puces 30₁, 30₂ lors de l'amincissement.

Le retrait de la couche de support 2 peut être réalisé en deux phases.

Selon une première phase, on retire tout d'abord par exemple de l'ordre de 70% à 95% de l'épaisseur de la couche de support 2 du substrat 1 par un procédé d'enlèvement de matière selon une technique de meulage (« grinding » selon la terminologie anglo-saxonne).

Puis, selon une deuxième phase, on enlève les 20% à 5% par gravure avec arrêt sur la couche isolante 3 du substrat. Cette gravure peut être effectuée par voie sèche en utilisant une technique de type RIE (pour « Reactive Ion Etching ») ou une gravure par voie humide dans une solution chimique par exemple à base de TMAH. Avec une solution de TMAH de concentration de 20 à 50 % en poids avec une température de 50 à 90°, on peut obtenir une vitesse de gravure de l'ordre de 0.2 à 1 µm×min⁻¹. Une telle solution permet de réaliser une gravure sélective par rapport à une couche isolante 2 du support à base d'oxyde.

Cette couche isolante 2 est alors conservée.

On peut ensuite réaliser des éléments de connexions 80a, 80b respectivement sur les zones dopées 8a, 8b (figure 2L). Ces éléments de connexions 80a, 80b sont avantageusement courts et ont en particulier une longueur inférieure à 1 µm de long. Dans le cas où la couche isolante 3 a été préservée on réalise ces éléments de connexion 80a, 80b à travers la couche isolante 3 et éventuellement à travers une ou plusieurs couches isolantes 85 supplémentaires formées sur la deuxième face de la première puce 30₁. Les éléments de connexion 80a, 80b sont en contact avec les zones dopées 8a, 8b.

La formation des éléments de connexion 80a, 80b peut comprendre par exemple un dépôt par électrolyse ou par technique PVD (« Physical Vapor Déposition ») de matériau conducteur tel que par exemple de l'AlSi, du W, du Pt, de l'Au, de l'Al, du NiSi.

Les éléments 80a, 80b de connexion peuvent avoir un diamètre ou une largeur typiquement compris(e) par exemple entre 100 nm et plusieurs dizaines de microns typiquement de l'ordre de 3 µm.

Les éléments 80a, 80b de connexion peuvent également avoir une hauteur comprise par exemple entre 10 nm et plusieurs µm, par exemple de l'ordre de 400 nm.

Les éléments de connexion 80a, 80b peuvent être formés chacun d'un via conducteur 82 et/ou d'une ligne conductrice 83 se terminant par exemple par un plot conducteur 81 en surface de l'assemblage.

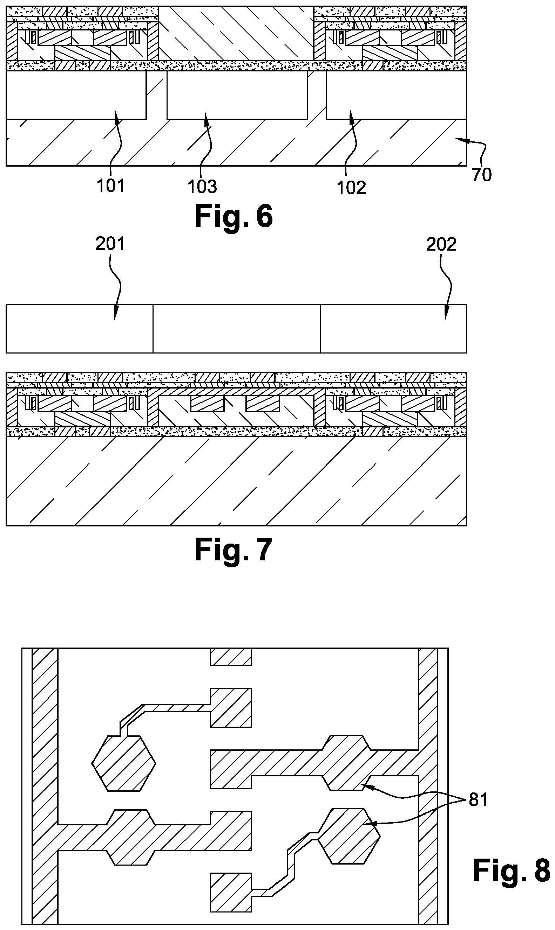

Un plot conducteur 81 par exemple de largeur supérieure à 70 µm et de longueur supérieure à 70 µm est par exemple réalisé afin de permettre d'accueillir des micro-pointes d'un système électrique externe adapté pour réaliser des mesures électriques du nano-objet 50. Un exemple d'agencement de plots conducteurs 81 en surface de l'assemblage support-puce est donné sur la figure 8.

Une possibilité de mise en oeuvre du dispositif prévoit la formation d'éléments de connexion permettant d'interconnecter différentes puces 30₁, 30₂, entre elles et/ou différents nano-objets entre eux.

On peut assurer une reprise de contact collective entre toutes les puces collées pour effectuer une mesure électrique collective ou sur certaines puces. Une telle reprise de contact collective permet de mesurer en série plusieurs nano-objets et donc d'augmenter le signal électrique injecté à un nano-objet.

Une variante de réalisation de l'exemple de procédé précédemment décrit comprend, après l'étape de formation du nano-objet 50 décrite en liaison avec la figure 2G, de rapporter à nouveau un capot de protection temporaire sur la première face du substrat 1, de sorte à protéger le nano-objet 50. Un collage du même capot temporaire 20, ou d'un nouveau capot temporaire permet d'assurer une protection hermétique du nano-objet 50 tant que l'assemblage avec le support 70 n'est pas réalisé.

Une autre variante prévoit d'utiliser une couche d'encapsulation temporaire du nano-objet, que l'on retire avant de réaliser l'assemblage entre la puce 30₁ et le support 70

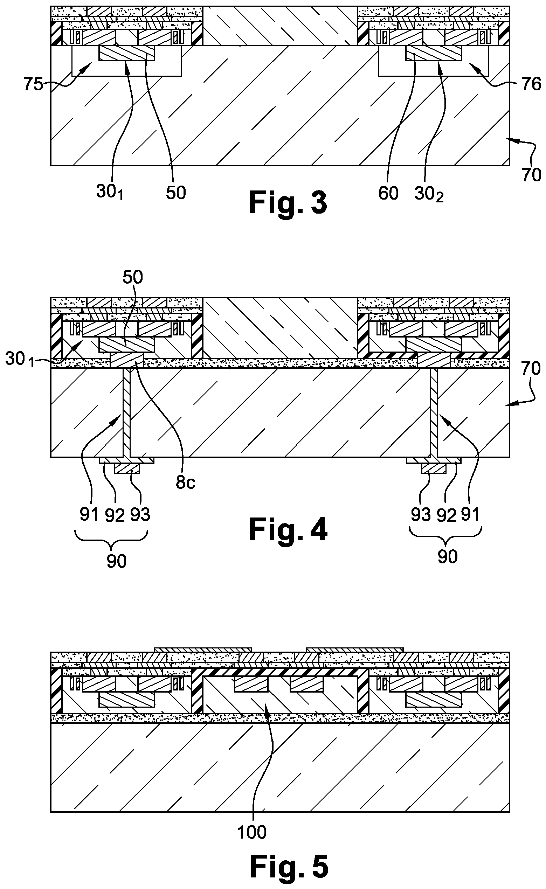

Selon une autre variante illustrée sur la figure 3 de l'un ou l'autre des exemples décrits précédemment, le support 70 sur lequel on assemble les puces 30₁, 30₂ est doté sur sa face supérieure de cavités 75, 76 dans lesquelles les nano-objets 50, 60 des puces 30₁, 30₂ sont logés.

De telles cavité 75, 76 permettent de réaliser un assemblage des puces 30₁, 30₂ sur le support 70 sans que les nano-objets 50, 60 sur lesquels ces puces 30₁, 30₂ sont disposées ne soient écrasés.

En plus de permettre d'assurer une protection des nano-objets 50, 60, de telles cavité 75, 76 permettent également de rendre le dispositif plus compact. Les cavités 75, 76 ont des dimensions prévues supérieures à celles des nano-objet 50. A titre d'exemple des cavités 75, 76 ayant une surface comprise entre 300 nm² et plusieurs centaines de µm² et une profondeur entre 500 nm² à plusieurs centaines de µm² peuvent être prévues. Les cavités 75, 76 sont réalisées par exemple par des étapes de photolithographie et de gravure.

Sur la figure 4, une variante de réalisation du dispositif prévoit un élément 90 de connexion supplémentaire traversant l'épaisseur du support 70 et débouchant sur la face inférieure F₂ du support 70 afin de permettre d'établir une connexion électrique entre un nano-objet 50 disposé du côté de la face supérieure F₁ du support et un système électrique extérieur (non représenté). Cet élément de connexion 90 supplémentaire peut être formé par exemple d'un via 91 s'étendant entre la face inférieure F₂ et la face supérieure F₁ du support 70, et d'au moins une ligne conductrice 92 et/ou d'un plot conducteur 93 agencé contre la face inférieure F₂ du support 70. L'élément de connexion 91 supplémentaire peut être connecté à une zone conductrice 8c supplémentaire réalisée sur la première face de la puce 30₁ et en contact avec le nano-objet 50.

Dans un autre exemple de réalisation illustré sur la figure 5, on prévoit d'intégrer un circuit électronique 100 disposé sur la face supérieure F1 du support 70. Ce circuit électronique 100, par exemple réalisé en technologie CMOS, est doté d'un ou plusieurs composants actifs. Le circuit électronique 100 peut être muni d'un ou plusieurs étages d'amplification et/ou de filtrage de signal issu de l'une ou l'autre des puces 30₁, 30₂.

Le circuit électronique 100 peut également comprendre un dispositif d'adressage des puces 30₁, 30₂.

Dans l'exemple de réalisation illustré sur la figure 6, c'est le support 70 lui-même qui comporte au moins un circuit électronique actif, et en particulier un premier circuit 101 actif sur lequel la première puce 30₁ est située et connectée ainsi qu'un deuxième circuit 102 actif sur laquelle la deuxième puce 30₂ est agencée et connectée. Le support 70 peut également comprendre un bloc 103 doté de composants passifs entre le premier circuit actif 101 et le deuxième circuit actif 102.

Dans l'exemple de réalisation illustré sur la figure 7, après avoir réalisé l'assemblage du support 70 et des puces 30₁, 30₂, on rapporte des circuits sur ces puces 30₁, 30₂, et en particulier un premier circuit actif 201 que l'on agence sur la première puce 30₁ et un deuxième circuit actif 202 que l'on dispose sur la deuxième puce 30₂. Comme dans les exemples donnés précédemment, les circuit actifs 201, 202 formés sur la première puce 30₁ et sur la deuxième puce 30₂ peuvent être dotés de moyens d'amplification et/ou de filtrage.

Un dispositif tel que décrit précédemment formé d'un assemblage entre au moins une puce et un support peut lui-même être reporté sur un autre support, éventuellement de taille plus importante, ou bien être reporté sur assemblage du même type afin de réaliser un dispositif à plusieurs étages de puces et de nano-objets.

Un dispositif tel que décrit précédemment trouve des applications notamment en électronique, en optique, en chimie et en biologie.

En particulier, elle peut permettre de produire, d'une part, un dispositif de caractérisation moléculaire et, d'autre part, des puces hybrides, par exemple des circuits hybrides MOS/molécules.

L'invention permet, entre autres, d'intégrer l'électronique moléculaire à la microélectronique, en particulier à la technologie CMOS.

L'invention propose, entre autres, un dispositif permettant de caractériser et d'exploiter les propriétés électriques, optiques, chimiques, voire biologiques, de molécules que l'on a synthétisées à dessein. Ce dispositif est obtenu à l'aide d'outils, de procédés et d'infrastructures qui ont été développés en microélectronique pour la fabrication de transistors MOS avancés (transistors à faible largeur de grille).

L'invention propose aussi une nouvelle architecture permettant d'intégrer à la fois des composants moléculaires et des composants microélectroniques sur le même substrat.

## Revendications

1. Dispositif pour connecter au moins un nano-objet à un système électrique externe (SEE), le dispositif comprenant:
un support (70),
- au moins une première puce (30₁) dotée de plusieurs zones conductrices (8a, 8b) et d'au moins un premier nano-objet (50) connecté auxdites zones conductrices, le premier nano-objet (50) étant connecté à une première zone conductrice (8a) et à une deuxième zone conductrice (8b) parmi lesdites zones conductrices (8a, 8b), la première zone conductrice (8a) et la deuxième zone conductrice (8b) étant disjointes et s'étendant dans un même plan parallèle au plan principal du support,
la première puce étant assemblée sur un support (70) de sorte que le premier nano-objet est disposé en regard d'une face supérieure (F1) du support, une face inférieure (F2) du support formant une face arrière (B) du dispositif, ladite face inférieure étant opposée à ladite face supérieure du support, le dispositif comportant en outre une face avant (A), opposée à ladite face arrière, la face avant étant dotée de plusieurs éléments de connexion (80a, 80b) aptes à être connectés au système électrique externe et disposés respectivement sur et en contact respectivement de ladite première zone conductrice (8a) et de ladite deuxième zone conductrice (8b) de la première puce, les éléments de connexion (80a, 80b) étant accessibles du côté de la face avant du dispositif.

2. Dispositif selon la revendication 1, dans lequel au moins une deuxième puce (30₂) est disposée sur le support (70), la deuxième puce étant également dotée d'une ou plusieurs autres zones conductrices (8a, 8b) et d'au moins un deuxième nano-objet (60) connecté auxdites autres zones conductrices.

3. Dispositif selon l'une des revendications 1 ou 2, dans lequel le support (70) comporte au moins une cavité (75) au niveau de sa face supérieure (F1), le premier nano-objet (50) étant logé dans la cavité.

4. Dispositif selon l'une des revendications 1 à 3, comprenant en outre au moins un autre élément de connexion (90) électrique connecté au premier nano-objet et traversant le support (70), l'autre élément de connexion débouchant sur la face inférieure (F2) du dispositif opposée à la face supérieure (A).

5. Dispositif selon l'une des revendications 1 à 4, comprenant en outre au moins un circuit (100) doté d'un ou plusieurs composant(s) actif(s) et/ou passif(s), le circuit étant disposé sur la face supérieure (F1) du support (70) ou étant intégré au support (70) ou étant disposé sur la première puce (30₁).

6. Dispositif selon la revendication 5, dans lequel le circuit est doté de moyens d'amplification et/ou de filtrage.

7. Dispositif selon la revendication 6, dans lequel les zones conductrices sont des zones dopées distinctes formées dans une couche semi-conductrice (4).

8. Procédé de réalisation d'un dispositif pour connecter au moins un nano-objet à un système électrique externe, le procédé comprenant des étapes consistant à :
- assembler sur un support une première puce (30₁) dotée de plusieurs zones conductrices (8a, 8b) et d'au moins un premier nano-objet (50), le premier nano-objet (50) étant connecté à une première zone conductrice (8a) et à une deuxième zone conductrice (8b) parmi lesdites zones conductrices (8a, 8b) la première zone conductrice (8a) et la deuxième zone conductrice (8b) étant disjointes et s'étendant dans un même plan parallèle au plan principal du support, l'assemblage de la première puce sur le support (70) étant réalisé de sorte que le premier nano-objet est disposé en regard d'une face supérieure (F₁) du support, une face inférieure (F2) du support formant une face arrière du dispositif, ce dernier comportant en outre une face avant (A) opposée à ladite face arrière,
- réaliser du côté de la face avant (A) du dispositif plusieurs éléments de connexion disposés sur et en contact disposés respectivement sur et en contact respectivement de ladite première zone conductrice (8a) et de ladite deuxième zone conductrice (8b).

9. Procédé selon la revendication 8, dans lequel le nano-objet (50) est situé sur une première face de la première puce (30₁), opposée à une deuxième face, le procédé comprenant en outre entre l'assemblage et la réalisation des premiers éléments de connexion (80a, 80b), une étape consistant à retirer une épaisseur de la première puce (30₁) du côté de sa deuxième face.

10. Procédé selon l'une des revendications 8 ou 9, dans lequel la première puce (30₁) est formée à partir d'un substrat sur lequel lesdites premières zones conductrices sont formées, le procédé comprenant en outre une étape de découpe du substrat pour délimiter ladite première puce .

11. Procédé selon la revendication 10, dans lequel le nano-objet est formé sur une première face de la première puce (30₁) après l'étape de découpe du substrat, et dans lequel, préalablement à la découpe on forme un capot de protection sur la première face de la première puce, le capot de protection étant retiré préalablement à la formation du premier nano-objet (50) sur la première face de la première puce.

12. Procédé selon l'une des revendications 8 à 11, dans lequel la première puce (30₁) est formée à partir d'un substrat, le procédé comprenant en outre la formation du premier nano-objet sur la première puce, le premier nano-objet étant positionné sur une zone d'intérêt de la première puce dans laquelle se situent les premières zones conductrices à l'aide de motifs (5) servant de repères délimitant la zone d'intérêt.

13. Procédé selon l'une des revendications 8 à 12, dans lequel après assemblage de la première puce (30₁) sur le support, on forme une paroi avantageusement isolante (91) sur tout ou partie du pourtour de la première puce.

14. Procédé selon l'une des revendications 8 à 13, dans lequel l'assemblage de la première puce (30₁) et du support (70) est réalisé par adhésion moléculaire.

15. Procédé selon l'une des revendications 8 à 14, dans lequel préalablement à l'assemblage, le procédé comprend la formation du premier nano-objet sur la première puce, cette formation étant réalisée par fonctionnalisation ou greffage, ou collage, ou dépôt suivi d'une structuration.

## Patentansprüche

1. Vorrichtung zum Verbinden von wenigstens einem Nanoobjekt mit einem externen elektrischen System (SEE), wobei die Vorrichtung umfasst:
einen Träger (70),
wenigstens einen ersten Chip (30₁), welcher mit mehreren leitfähigen Zonen (8a, 8b) versehen ist, und wenigstens ein erstes Nanoobjekt (50), welches mit den leitfähigen Zonen verbunden ist, wobei das erste Nanoobjekt (50) mit einer ersten leitfähigen Zone (8a) und einer zweiten leitfähigen Zone (8b) aus den leitfähigen Zonen (8a, 8b) verbunden ist, wobei die erste leitfähige Zone (8a) und die zweite leitfähige Zone (8b) getrennt sind und sich in einer gemeinsamen Ebene parallel zu der Hauptebene des Trägers erstrecken,
wobei der erste Chip an einem Träger (70) derart angebracht ist, dass das erste Nanoobjekt gegenüber einer oberen Fläche (F1) des Trägers angeordnet ist,
wobei eine untere Fläche (F2) des Trägers eine hintere Fläche (B) der Vorrichtung bildet, wobei die untere Fläche der oberen Fläche des Trägers entgegengesetzt ist, wobei die Vorrichtung ferner eine vordere Fläche (A) entgegengesetzt zu der hinteren Fläche umfasst, wobei die vordere Fläche mit mehreren Verbindungselementen (80a, 80b) versehen ist, welche in der Lage sind, mit dem externen elektrischen System verbunden zu sein und an und in Kontakt mit der ersten leitfähigen Zone (8a) bzw. der zweiten leitfähigen Zone (8b) des ersten Chips angeordnet zu sein, wobei die Verbindungselemente (80a, 80b) von der Seite der vorderen Fläche der Vorrichtung her zugänglich sind.

2. Vorrichtung nach Anspruch 1, wobei wenigstens ein zweiter Chip (30₂) an dem Träger (70) angeordnet ist, wobei der zweite Chip ferner mit einer oder mehreren weiteren leitfähigen Zonen (8a, 8b) versehen ist und mit wenigstens einem zweiten Nanoobjekt (60), welches mit den weiteren leitfähigen Zonen verbunden ist.

3. Vorrichtung nach einem der Ansprüche 1 oder 2, wobei der Träger (70) wenigstens einen Hohlraum (75) auf dem Niveau seiner oberen Fläche (F1) umfasst, wobei das erste Nanoobjekt (50) in dem Hohlraum aufgenommen ist.

4. Vorrichtung nach einem der Ansprüche 1 bis 3, ferner umfassend wenigstens ein weiteres elektrisches Verbindungselement (90), welches mit dem ersten Nanoobjekt verbunden ist und den Träger (70) durchquert, wobei das weitere Verbindungselement an der unteren Fläche (F2) der Vorrichtung entgegengesetzt zu der oberen Fläche (A) mündet.

5. Vorrichtung nach einem der Ansprüche 1 bis 4, ferner umfassend wenigstens eine Schaltung (100), welche mit einer oder mehreren aktiven und/oder passiven Komponente/n versehen ist, wobei die Schaltung an der oberen Fläche (F1) des Trägers (70) angeordnet ist oder in dem Träger (70) integriert ist oder an dem ersten Chip (30₁) angeordnet ist.

6. Vorrichtung nach Anspruch 5, wobei die Schaltung mit Verstärkungs- und/oder Filtermitteln versehen ist.

7. Vorrichtung nach Anspruch 6, wobei die leitfähigen Zonen unterschiedlich dotierte Zonen sind, welche in einer Halbleiterschicht (4) gebildet sind.

8. Verfahren zum Herstellen einer Vorrichtung zum Verbinden von wenigstens einem Nanoobjekt mit einem externen elektrischen System, wobei das Verfahren die Schritte umfasst, bestehend aus:
- Anbringen eines ersten Chips (30₁), welcher mit mehreren leitfähigen Zonen (8a, 8b) und wenigstens einem ersten Nanoobjekt (50) versehen ist, auf einem Träger, wobei das erste Nanoobjekt (50) mit einer ersten leitfähigen Zone (8a) und mit einer zweiten leitfähigen Zone (8b) aus den leitfähigen Zonen (8a, 8b) kontaktiert wird, wobei die erste leitfähige Zone (8a) und die zweite leitfähige Zone (8b) getrennt sind und sich in einer gemeinsamen Ebene erstrecken, welche parallel zu der Hauptebene des Trägers ist, wobei das Anbringen des ersten Chips auf dem Träger (70) derart durchgeführt wird, dass das erste Nanoobjekt gegenüber einer oberen Fläche (F₁) des Trägers angeordnet wird, wobei eine untere Fläche (F2) des Trägers eine hintere Fläche der Vorrichtung bildet, wobei letztere ferner eine vordere Fläche (A) entgegengesetzt zu der hinteren Fläche umfasst,
- Herstellen von mehreren Verbindungselementen an der Seite der vorderen Fläche (A) der Vorrichtung, welche an und in Kontakt mit der ersten leitfähigen Zone (8a) bzw. der zweiten leitfähigen Zone (8b) angeordnet werden.

9. Verfahren nach Anspruch 8, wobei das Nanoobjekt (50) an einer ersten Fläche des ersten Chips (30₁) entgegengesetzt zu einer zweiten Fläche platziert wird, wobei das Verfahren ferner zwischen dem Anbringen und dem Herstellen der ersten Verbindungselemente (80a, 80b) einen Schritt umfasst, welcher aus einem Entfernen einer Dicke des ersten Chips (30₁) auf der Seite seiner zweiten Fläche besteht.

10. Verfahren nach einem der Ansprüche 8 oder 9, wobei der erste Chip (30₁) ausgehend von einem Substrat gebildet wird, an welchem die ersten leitfähigen Zonen gebildet werden, wobei das Verfahren ferner einen Schritt eines Zuschneidens des Substrats zum Begrenzen des ersten Chips umfasst.

11. Verfahren nach Anspruch 10, wobei das Nanoobjekt an einer ersten Fläche des ersten Chips (30₁) nach dem Schritt des Zuschneidens des Substrats gebildet wird, und wobei vor dem Zuschneiden eine Schutzhaube auf der ersten Fläche des ersten Chips gebildet wird, wobei die Schutzhaube vor dem Bilden des ersten Nanoobjekts (50) an der ersten Fläche des ersten Chips entfernt wird.

12. Verfahren nach einem der Ansprüche 8 bis 11, wobei der erste Chip (30₁) ausgehend von einem Substrat gebildet wird, wobei das Verfahren ferner das Bilden des ersten Nanoobjekts an dem ersten Chip umfasst, wobei das erste Nanoobjekt an einer Zone von Interesse des ersten Chips positioniert wird, in welcher sich die ersten leitfähigen Zonen befinden, mit Hilfe von Motiven (5), welche als Markierungen diesen, welche die Zone von Interesse begrenzen.

13. Verfahren nach einem der Ansprüche 8 bis 12, wobei nach dem Anbringen des ersten Chips (30₁) auf dem Träger eine, vorzugsweise isolierende, Wand (91) an dem gesamten Umfang des ersten Chips oder einem Teil davon gebildet wird.

14. Verfahren nach einem der Ansprüche 8 bis 13, wobei das Anbringen des ersten Chips (30₁) und des Trägers (70) durch Molekularadhäsion durchgeführt wird.

15. Verfahren nach einem der Ansprüche 8 bis 14, wobei vordem Anbringen das Verfahren das Bilden des ersten Nanoobjekts an dem ersten Chip umfasst, wobei dieses Bilden durch Funktionalisieren oder Aufpropfen oder Aufkleben, oder Ablagerung nach einer Strukturierung durchgeführt wird.

## Claims

1. A device for connecting at least one nano-object to an external electrical system (SEE), the device including:
- a support (70);
- at least one first chip (30₁) provided with several conducting areas (8a, 8b) and at least one first nano-object (50) connected to said conducting areas, the first nano-object (50) being connected to a first conducting area (8a) and to a second conducting area (8b) among said conducting areas (8a, 8b), the first conducting area (8a) and the second conducting area (8b) being separate and extending in a same plane parallel to the main plane of the support,
the first chip being assembled on a support (70) such that the first nano-object is arranged facing an upper face (F₁) of the support, a lower face (F₂) of the support forming a rear face (B) of the device, said lower face being opposite to said upper face of the support, the device further comprising a front face (A), opposite to said rear face, the front face being provided with several connection elements (80a, 80b) provided for connection to the external electrical system and arranged respectively on and in contact respectively with said first conducting area (8a) and said second conducting area (8b) of the first chip, the connection elements (80a, 80b) being accessible from the side of the front face of the device.

2. The device according to claim 1, wherein at least one second chip (30₂) is arranged on the support (70), the second chip being also provided with one or more other conducting areas (8a, 8b) and at least one second nano-object (60) connected to said other conducting areas.

3. The device according to claim 1 or 2, wherein the support (70) comprises at least one cavity (75) at the level of its upper face (F₁), the first nano-object (50) being housed in the cavity.

4. The device according to one of claims 1 to 3, further including at least one other electrical connection element (90) connected to the first nano-object and traversing the support (70), the other connection element emerging on the lower face (F₂) of the device opposite to the upper face (A).

5. The device according to one of claims 1 to 4, further including at least one circuit (100) provided with one or more active and/or passive component(s), the circuit being arranged on the upper face (F₁) of the support (70) or being integrated in the support (70) or being arranged on the first chip (30₁).

6. The device according to claim 5, wherein the circuit is provided with amplification and/or filtering means.

7. The device according to claim 6, wherein the conducting areas are distinct doped areas formed in a semiconductor layer (4).

8. The method for fabricating a device for connecting at least one nano-object to an external electrical system, the method including the steps consisting in:
- assembling on a support a first chip (30₁) provided with one or more conducting areas(8a, 8b) and at least one first nano-object (50), the first nano-object (50) being connected to a first conducting area (8a) and to a second conducting area (8b) among said conducting areas (8a, 8b), the first conducting area (8a) and the second conducting area (8b) being separate and extending in a same plane parallel to the main plane of the support, the assembly of the first chip on the support (70) being carried out such that the first nano-object is arranged facing an upper face (F₁) of the support, a lower face (F₂) of the support forming a rear face of the device, the latter further comprising a front face (A) opposite to said rear face,
- producing on the side of the front face (A) of the device several connection elements arranged respectively on and in contact respectively with said first conducting area (8a) and said second conducting area (8b).

9. The method according to claim 8, wherein the nano-object is situated on a first face of the first chip (30₁), opposite to a second face, the method further including between the assembly and the production of the first connection element (80a, 80b), a step consisting in removing a thickness of the first chip (30₁) from the side of its second face.

10. The method according to one of claims 8 or 9, wherein the first chip (30₁) is formed from a substrate on which said first conducting areas are formed, the method further including a step of cutting of the substrate to delimit said first chip.

11. The method according to claim 10, wherein the nano-object is formed on a first face of the first chip (30₁) after the step of cutting of the substrate and in which, prior to cutting, a protective cover is formed on the first face of the first chip, the protective cover being removed prior to the formation of the first nano-object (50) on the first face of the first chip.

12. The method according to one of claims 8 to 11, wherein the first chip (30₁) is formed from a substrate, the method further including the formation of the first nano-object on the first chip, the first nano-object being positioned on an area of interest of the first chip in which are situated first conducting areas using patterns (5) serving as reference points delimiting the area of interest.

13. The method according to one of claims 8 to 12, wherein after assembly of the first chip (30₁) on the support, a wall, advantageously insulating (91), is formed on all or part of the perimeter of the first chip.

14. The method according to claims 8 to 13, wherein the assembly of the first chip (30₁) and the support (70) is carried out by molecular adhesion.

15. The method according to one of claims 8 to 14, wherein prior to assembly, the method includes the formation of the first nano-object on the first chip, this formation being carried out by functionalization or grafting, or bonding, or deposition followed by structuring.
